# EUROPEAN PATENT APPLICATION

(11) **EP 2 605 281 A1**
(43) Date of publication of application: **19.06.2013**
(21) Application number: 11193969.0
(22) Date of filing: 16.12.2011
(51) Int. Cl.: H01L 27/32, H04M 1/02

(54) **OLED display provided with solar cell means**

(71) Applicant: Intivation Holding B.v., 1075 AT Amsterdam (NL)
(72) Inventor: Osinga, Anne J., 3235 AC Rockanje (NL); Kardolus, Menno, 1115 DL Duivendrecht (NL); Gröninger, Mark Alexander, 4904 SJ Oosterhout (NL)
(74) Representative: Klavers, Cornelis

(57) **Abstract**

It is described a device comprising a light translucent organic light emitting (OLED) display having a front side for displaying information, images and/or video and a back side, and solar cell means provided on the back side of the display. Sunlight shining through the display can then be converted to electric power. The solar cell means may be back connect solar cell means comprising a one sided evenly and uniformly coloured front side facing the back side of the OLED display and a back connect side which is soldered to one side of a printed circuit board (PCB) whose opposite side is fastened to the housing of the device. Advantageously a smooth undisturbed background is visible through the display. The device is a portable or mobile device, a smart phone, an I-pad, an I-phone, an audio and/or video player, an mp3 or mp4 player, a tablet PC, a laptop, a navigation device for vehicles, such a for personal navigation, cars, ships, air planes and the like.

## Description

The present invention relates to a device comprising a display having a front side for display of information, images and/or video, and having a back side.

Devices such as mobile devices for example mobile phones provided with displays used for displaying thereon information c.q. data, such as text, icons, images, video and the like are generally known. Solar powered devices having solar cells provided on the back of the housing of the device meant for charging an accumulator in the device are also known.

As the functionalities of these devices are increasing there is a ever growing demand for electric device power. If the device is provided with a display the housings device is normally turned upside down to allow solar cell means provided on the back side of the housing to receive solar energy, which activates solar charging.

It is an object of the present invention to provide an improved device having solar power charging capabilities, but not requiring special handling for activating solar charging.

Thereto the device according to the invention has the characterising features of claim 1.

It is an advantage of the device according to the present invention that the light translucent OLED display while continuing its normal way of functioning for the display of data and video can now also be used for passing on and letting through light, in particular sunlight, to underlying solar cell means provided on the back side of the display. The light energy reaching these solar cell means lying in the background protected by the display can advantageously be used to power the device instantly and/or for charging a rechargeable battery, capacitor or accumulator normally present in the device.

If left in the light such as the sunlight the device need not be turned over and laid on an underground to expose solar cell means possibly present on the back side of the housing of the device, which would increase the chances to damaging the display. The device according to the invention can simply be left display up in the sun to convert solar energy into electric energy, with no chances for damaging the display due to the presence of some article on the underground.

The translucent or light transparent display which is flat nowadays, but could well be curved or even flexible can be any type of OLED display such as a passive matrix or active matrix OLED display. These kinds of matrix displays if not operational pass nowadays approximately 50 % of the light spectrum for which the solar cell means are sensitive and this represents energy which is now effectively used to establish power savings by the device according to the invention.

A practically preferred embodiment of the device according to the invention is characterised in that the solar cell means are back connect solar cell means.

This way the other side of solar cell means does not comprise cell patterns, which avoids the observation through the display of such a solar cell grid pattern. The fact that such grid patterns used to blur images shown on the display prevents a skilled person from even trying to provide common solar cell means on the back side of the OLED display.

A further preferred embodiment of the device according to the invention is characterised in that the back connect solar cell means comprise a one sided evenly and uniformly coloured front side facing the back side of the OLED display and a back connect side which is soldered to one side of a printed circuit board (PCB) whose opposite side is fastened to the housing of the device.

Further advantageously in the absence of any grid pattern visible through the front side of the OLED display, an evenly and uniformly coloured inviting background is now observable through the OLED display together with the text, icons, images and videos made visible by the OLED display.

Another embodiment of the device according to the invention is characterised in that the device comprises further solar cell means fastened to the housing of the device, which may also be back connect solar cell means.

This way at wish all sides of the housing of the device may be provided with solar cell means. This makes the solar charging practically independent on the particular orientation wherein the device housing is put on an underground in the sunlight.

Still another embodiment of the device according to the invention is characterised in that the solar light translucent organic light emitting (OLED) display also has one or more side edges at least one being a bevelled side edge provided with inner light reflective material whereby the opposite side of the bevelled side edge is provided with still further solar cell means for receiving at least inner light emitted by the OLED display.

OLED displays provide backlighting by themselves and this represents energy, which can be reused and effectively reintroduced into the power supply system of the device by applying the above measures. This way the surplus of light such as internally therein caught sunlight and/or at least light generated by the OLED display can be coupled out and converted by the still further solar cell means into electric power for use in the device according to the invention.

If the inner reflective material is capable of passing external solar light to the still further solar cell means, such as in cases wherein via edges and/or extended solar cell parts external solar energy can be received this would provide extra power, if needed.

In such cases it is preferred to have the still further solar cell means in the form of back connect solar cell means, in order to avoid possible disturbing reflections to be visible on the OLED display.

The principles outlined so far are applicable in a variety of devices, in particular mobile devices as detailed hereinafter.

At present the device according to the invention will be elucidated further together with its additional advantages while reference is being made to the appended drawing, wherein similar components are being referred to by means of the same reference numerals. In the drawing:
Figs. 1A and 1B show two embodiments of possible outlines of layers building up the device according to the invention;
Figs. 2A and 2B show various details of sandwiches of a back connect solar cell and a PCB applicable in the embodiments of figs. 1A and 1B;
Figs. 3A and 3B show a general layout and details respectively of a further embodiment of the device according to the invention; and
Fig. 4 shows a particular embodiment of the device according to the invention.

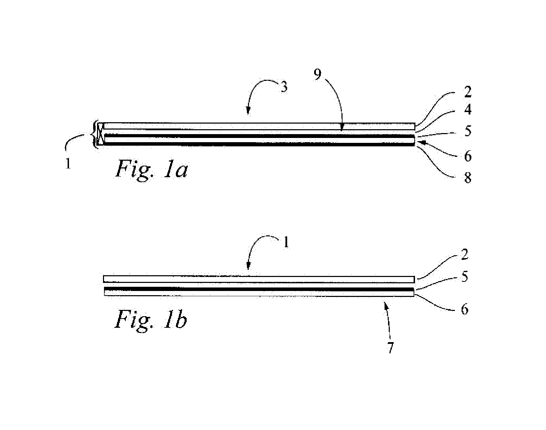

Figs. 1A and 1B schematically show of a device 1 being a portable or mobile device, a smart phone, an I-pad, an I-phone, an audio and/or video player, an mp3 or mp4 player, a tablet PC, a laptop, a navigation device for vehicles, such a for personal navigation, cars, ships, air planes and the like. The right part as shown is normally the flat upper part of the device 1, which comprises a light translucent organic light emitting (OLED) display 2 having a front side 3 for displaying information, images and/or video and a back side 4. Solar cell means 5 are provided on the back side 4 of the OLED display 2, which may be a passive matrix OLED display or an active matrix OLED display.

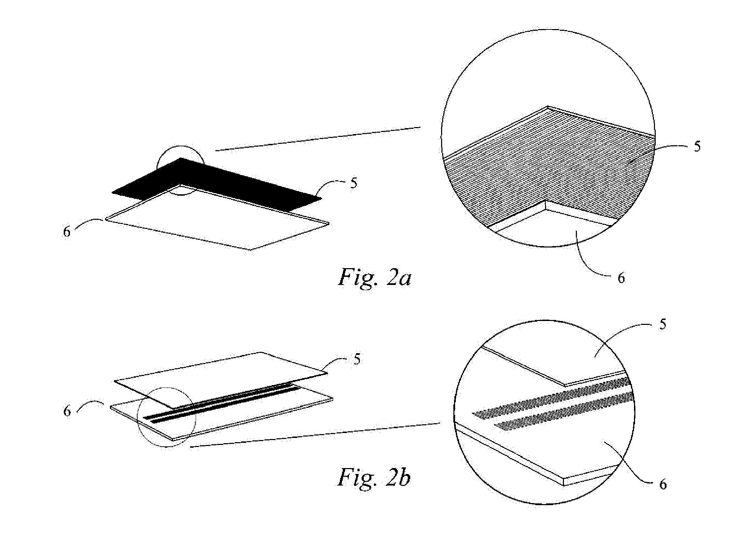

As shown in these figs. 1A and 1B, and further detailed in figs. 2A and 2B, the solar cell means 5 are a back connect solar cell means, which in practise allow the back connect side of these means 5 to be soldered to the upper side of a printed circuit board or PCB 6. Its opposite PCB side 7 is fastened to the housing of the device 1 or to further solar cell means 8 fastened to the device 1. The back side 4 of the OLED display 2 faces an evenly and uniformly coloured front side 9 of the solar cell means 5. This means that seen through the front side 3 no disturbing grid pattern is visible on the background of what is shown in the OLED 2.

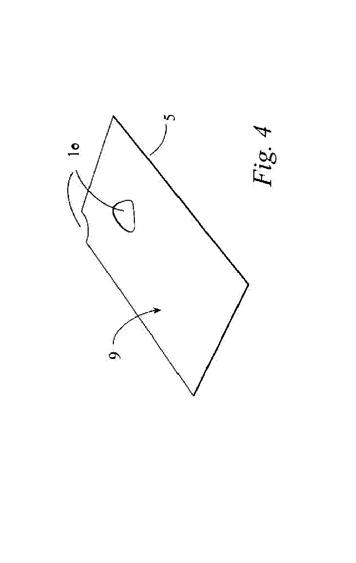

The back connect solar cell means 5 mentioned herein that is the front side 9 may be provided with a laser cut hole 10 as shown in fig. 4, whereby the laser must be a cooled -water cooled- laser in order not to damage the solar cell means 5. Practically the hole 10 has a desired peripheral contour, such as the outline of a logo or image, for example an apple. At wish the hole gives room for a camera lens to be provided in the hole 10.

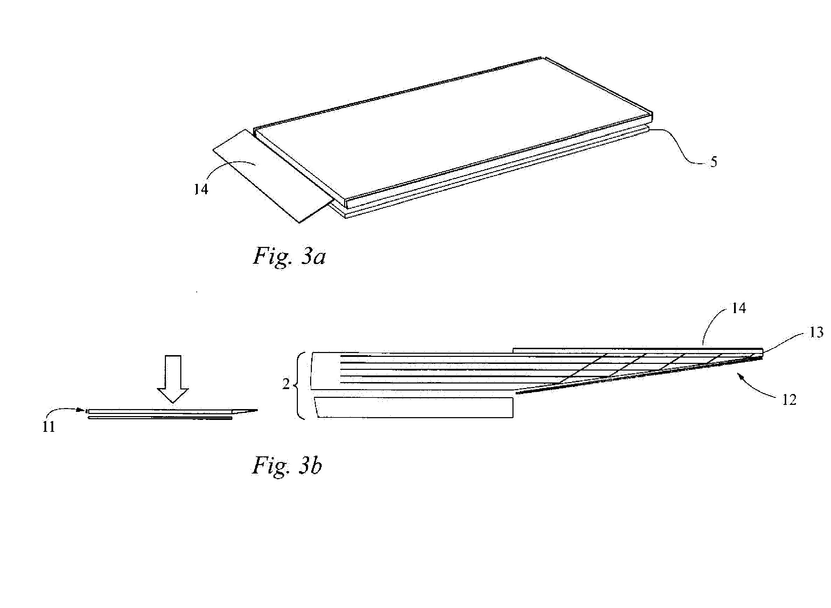

As shown in figs. 3A and 3B the solar light translucent organic light emitting display 2 also has one or more side edges 11. At least one thereof is a bevelled side edge 12 which is provided with an inner light reflective material 13, for example in the form of a reflective foil or a reflective layer. Light from within the OLED 2 is reflected by the material 13 on the bevelled edge 12 and internally reflected to still further solar cell means 14 provided on an opposing extension of the OLED 2. These means 14 receive at least inner light emitted by the OLED display and/or solar light coupled into and travelling in the OLED display 2. At least the light generated internally in the OLED 2 can now be reused in the device to derive power there from by means of a charge circuit (not shown) for example Intivations own very low power consuming and efficient converters coupled to the various solar cell means 5, 8, 14 preferably having the form of single cell means. These mentioned solar cell means may also be back connect solar cells in which case only one type of such means is required.

## Claims

1. A device comprising:
- a light translucent organic light emitting (OLED) display having a front side for displaying information, images and/or video and a back side, and
- solar cell means provided on the back side of the display.

2. Device according to claim 1, **characterised in that** the display is a flat OLED display.

3. Device according to claim 1 or 2, **characterised in that** the OLED display is a passive matrix or active matrix OLED display.

4. Device according to any of the claims 1-3, **characterised in that** the solar cell means are back connect solar cell means.

5. Device according to claim 4, **characterised in that** the back connect solar cell means comprise a one sided evenly and uniformly coloured front side facing the back side of the OLED display and a back connect side which is soldered to one side of a printed circuit board (PCB) whose opposite side is fastened to the housing of the device.

6. Device according to claim 5, **characterised in that** the device comprises further solar cell means fastened to the housing of the device or to the opposite side of the PCB.

7. Device according to claim 6, **characterised in that** the further solar cell means are back connect solar cell means.

8. Device according to any of the claims 1-7, **characterised in that** the solar light translucent organic light emitting (OLED) display also has one or more side edges at least one being a bevelled side edge provided with inner light reflective material whereby the opposite side of the bevelled side edge is provided with still further solar cell means for receiving at least inner light emitted by the OLED display and/or solar light coupled into the OLED display.

9. Device according to claim 8, **characterised in that** the OLED display has one or more side edges provided with light reflective means.

10. Device according to claim 8 or 9, **characterised in that** the inner reflective material which may be in the form of a foil or layer, is capable of reflecting the light received in the OLED display to the still further solar cell means.

11. Device according to any of the claims 8-10, **characterised in that** the still further solar cell means are back connect solar cell means.

12. Device according to any of the claims 1-11, **characterised in that** the device is a portable or mobile device, a smart phone, an I-pad, an I-phone, an audio and/or video player, an mp3 or mp4 player, a tablet PC, a laptop, a navigation device for vehicles, such a for personal navigation, cars, ships, air planes and the like.

13. Device according to any of the claims 1-12, **characterised in that** any of the earlier mentioned back connect solar cell means is provided with a laser cut hole having a desired peripheral contour, such as the outline of a logo or image, for example an apple, which device may have a camera lens behind c.q. in the hole.

14. Device according to any of the claims 1-13, **characterised in that** the device comprises a charge circuit coupled to the solar cell means which are single cell means.
